# EUROPÄISCHE PATENTSCHRIFT

(11) **EP 2 133 907 B1**
(45) Veröffentlichungstag und Bekanntmachung des Hinweises auf die Patenterteilung: **18.06.2014**
(21) Anmeldenummer: 08157885.8
(22) Anmeldetag: 09.06.2008
(51) Int. Cl.: H01L 21/20, H01L 21/02

(54) **Polykristalline Silizium Dünnschichten hergestellt durch Titan-unterstützten Metall-induzierten Schichtaustausch**
Polycrystalline silicon thin layers produced by titanium-supported metal-induced layer exchange
Couches fines de silicium poly-cristallin fabriquées par échange de couches induit par du métal et soutenu par du titane

(43) Veröffentlichungstag der Anmeldung: 16.12.2009
(60) Teilanmeldung: 12152997.8
(73) Patentinhaber: Dritte Patentportfolio Beteiligungsgesellschaft mbH & Co. KG, 12529 Schönefeld / Waltersdorf (DE)
(72) Erfinder: Stutzmann, Martin, 85435 Erding (DE); Lechner, Robert, 81373 München (DE); Scholz, Michael, 82288 Kottgeisering (DE)
(74) Vertreter: Meissner, Bolte & Partner GbR

(56) Entgegenhaltungen:
- JENS SCHNEIDER: "Nucleation and growth during the formation of polycrystalline silicon thin films" PHD THESIS, 2005, XP009109059 Berlin
- MASAO HIRASAKA: "CHARACTERIZATION OF ELECTRODE MATERIALS ADOPTED FOR A-SI:H SOLAR CELLS BY MEANS OF AUGER ELECTRON SPECTROSCOPY" SOLAR ENERGY MATERIALS, ELSEVIER SCIENCE PUBLISHERS B.V. AMSTERDAM, NL, Bd. 19, Nr. 3/05, 1. November 1989 (1989-11-01), Seiten 199-210, XP000084765
- BERGER S ET AL: "THE STRUCTURE AND COMPOSITION OF CONTACT MADE OF AL(2%CU)-TIW FILMSON AMORPHIZED SILICON" THIN SOLID FILMS, ELSEVIER-SEQUOIA S.A. LAUSANNE, CH, Bd. 176, Nr. 1, 1. September 1989 (1989-09-01), Seiten 131-142, XP000087271 ISSN: 0040-6090
- GJUKIC, MARIO: "Metal-induced crystallization of silicon-germanium alloys" REIHE: SELECTED TOPICS OF SEMICONDUCTOR PHYSICS AND TECHNOLOGY, Nr. 86, 2007, XP009109263 München & _, 2007, XP009109286 & _, 2007, XP009109276
- LECHNER, BISCHBECK, GJUKIC, STUTZMANN: "Thin polycrystalline SiGe films by aluminium-induced layer exchange" 19000101, Bd. 1, Nr. 5, 18. März 2004 (2004-03-18), Seiten 1131-1143, XP009109176 Weinheim

## Beschreibung

### Technisches Gebiet

Die Herstellung von kristallinen Silizium-Germanium (SiGe) Dünnschichten auf kostengünstigen Substraten wie z.B. Glas ist von fundamentaler Bedeutung für großflächige elektronische Bauelemente. Hierzu zählen beispielsweise Dünnschicht-Solarzellen und Bildschirme, die auf Basis der Dünnschicht-Transistor-Technologie (TFT-Technologle) beruhen.

Die Funktionsfähigkeit dieser Bauelemente wird in erster Linie durch die elektrischen Eigenschaften des halbleitenden Materials bestimmt. Diese Eigenschaften sind stark mit der mikroskopischen Struktur korreliert, wobei man zwischen amorphen, nanokristallinen, mikrokristailinen, polykristallinen und einkristallinen Materialien unterscheidet. Im Allgemeinen wird die Qualität der Bauelemente mit zunehmender Kristallinität (amorph → kristallin) verbessert. Die Schaltzeilen von amorphen TFT-Bildschirmen sind beispielsweise länger als die von mikrokristallinen, die Wirkungsgrade von amorphen Solarzellen geringer als die von polykristallinen.

### Stand der Technik

Zur Glas-konipatiblen Niedertemperatur-Kristallisation (T < 600°C) von amorphen Silizium-Germanium werden vor allem die Laser-induzierte Kristallisierung (Laser-induced Crystallization, LIC) und die Metal-induzierte Kristallisierung (Metal-induced Crystallization, MIC) wissenschaftlich untersucht bzw. industriell eingesetzt. Die Festphasen-Kristallisierung (Solid Phase Crystallization, SPC) erfordert Temperaturen größer als 600°C und ist nicht kompatibel mit der Verwendung von konventionellen Glas-Substraten.

Bei der LIC werden amorphe Halbleiterschichten durch intensives Laser-Licht kurzzeitig aufgeschmolzen (T- 1500°C), so dass sich mikrokristallines Material mit Korngrößen von bis zu 5 µm bildet [Eis03]. Im Gegensatz dazu stellt die MIC ein echtes Niedertemperatur-Verfahren (T < 600°C) dar [Her72]. Die Kristallisation von amorphen Halbleitern wurde sowohl in Metall/Halbleiter Schichtsystemen als auch in Metall-dotierten amorphen Schichten beobachtet [Rad91I, [Cha01].

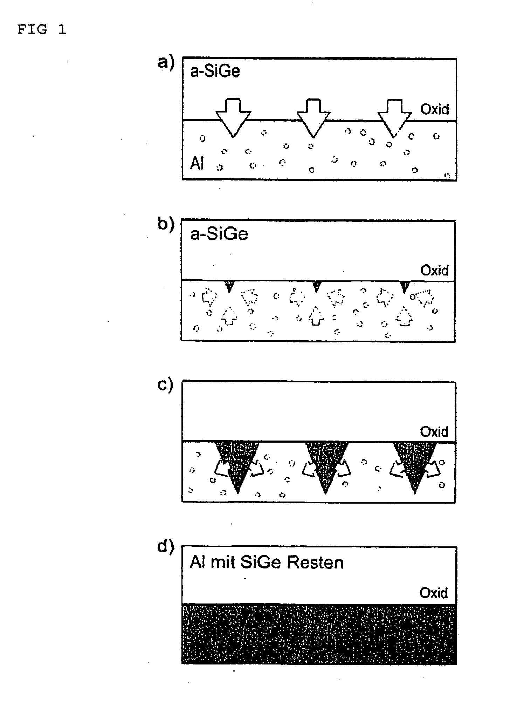

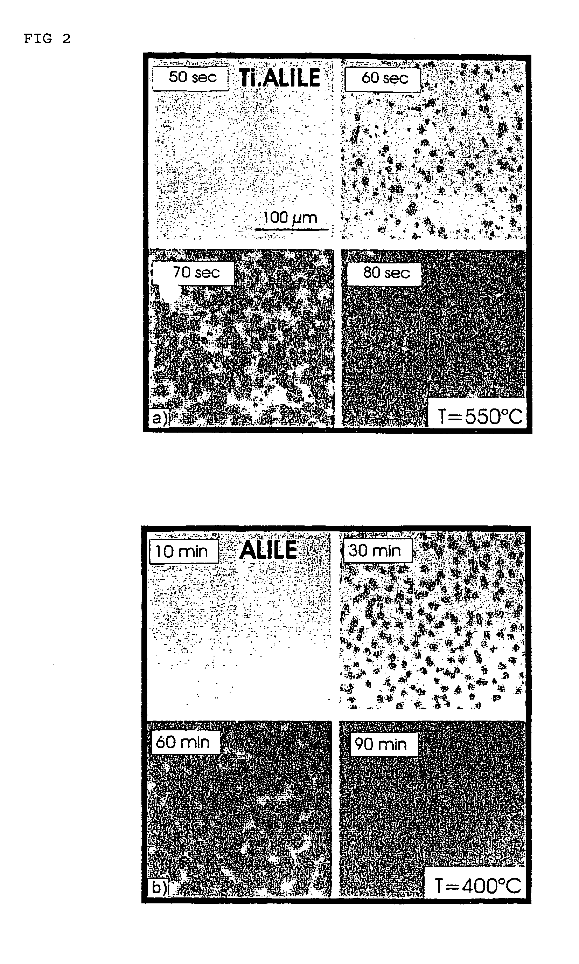

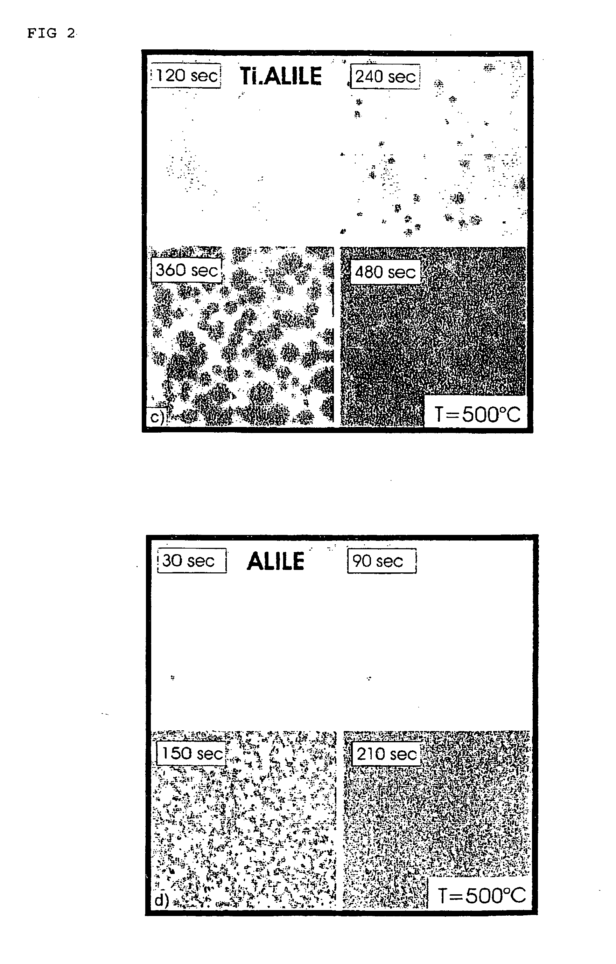

Ein viel versprechendes, großflächig anwendbares und zur Zeit intensiv erforschtes Verfahren stellt der Aluminium-induzierte Schichtaustausch (Aluminum-induced Layer Exchange, ALILE) von Silizium, Germanium bzw. Silizium-Germanium-Legierungen dar [Maj77], [Nas98], [Gju04]. Amorphes Silizium-Germanium wird dabei auf Aluminium-beschichtete Glassubstrate aufgebracht und unterhalb der eutektischen Temperatur des Aluminium-Silizium-Germanlum-Systems (Te = 420°C) getempert. Während des Temperns lösen sich Silizium- und Germanium-Atome aus der amorphen Schicht in der Aluminium-Schicht. Wenn die Sättigungsgrenze erreicht ist, fallen kristalline Si-Ge Keime aus. Diese wachsen lateral und bilden am Ende eine geschlossene polykristalline Schicht, welche die gleiche Schichtdicke aufweist, wie die ursprüngliche Aluminium-Schicht. In Abb. 1 ist das Verfahren schematisch dargestellt.
a) Typisches Schichtsystem für den Aluminium-induzierten Schichtaustausch von Silizium-Germanium. Zwischen dem Aluminium (ca. 200nm) und dem amorphen Sifizium-Germanium (ca. 200nm) befindet sich eine in der Skizze angedeutete dünne Aluminium-Oxid-Schicht. Wird diese Schichtstruktur bei Temperaturen unterhalb der eutektischen Temperatur des Aluminium-Silizium-Germanium-Systems (420 °C) getempert.
b) Es bilden sich an der Grenzfläche zwischen dem Aluminium und der amorphen SiGe-Schicht kristalline Silizium-Germanium-Keime aus, die in die Aluminium-Schicht hineinwachsen.
c) Das vertikale Wachstum wird durch die Substratoberfläche begrenzt Anschließend findet laterales Wachstum der Kristallite bis zur Bildung einer geschlossenen polykristallinen Silizium-Germanium-Schicht statt,
d) Das sich nach dem Prozess an der Oberfläche befindende Aluminium kann durch nasschemische Verfahren entfernt werden (z.B. Ätzen in Salzsäure). Zurück bleibt eine polykristalline Silizium-Germanium-Schicht auf Glas mit lateralen Kristallitgrößen bis zu 50 µm.

Dieser Prozess konnte in unserer Gruppe auf das Materialsystem: Silber Silizium-Germanium erweitert werden. Der Prozess verläuft makroskopisch analog zum ALILE-Prozess [Gju05].

In "Nucleation and Growth During the Formation of Polycrystalline Silicon Thin Films", Jens Schneider, PhD Thesis, TU Berlin, 2005, wird ein "Alile-Verfahren" zur Herstellung von polykristallinem Silizium erläutert. Bei diesem Verfahren wird zwischen einer Aluminiumschicht und einer amorphen Siliziumschicht eine permeable Membran eingesetzt. Als geeignete Membran wird Aluminiumoxid vorgeschlagen. Als Zwischenschicht wird eine Molybdänschicht vorgeschlagen.

### Nachteile bzw. Probleme der bekannten Technik

Beim ALILE Prozess mit Aluminiumoxid an der Grenzfläche ist für das Erlangen einer großkörnigen polykristallinen Schicht (Korngrößen > 20 µm) eine niedrige Prozesstemperatur (typischerweise unter 500°C) nötig. Dies führt aber zu sehr langsamen Prozessen, die mehrere Stunden dauern können.

Beim Silber-induzierten Schichtaustausch (AgILE) Prozess zeigte sich, das die Reproduzierbarkeit ein großes Problem darstellt. Dies liegt wahrscheinlich an der sehr instabilen Silberoxidschicht die bei dem Prozess eine Diffusionsbarriere darstellt und für den Schichtaustausch essentiell ist.

Beim AgILE Prozess ist im Gegensatz zum ALILE Prozess ein Schichtaustausch in umgekehrter Schichtfolge (Si/SiO2/Silber) nicht möglich. Diese Schichtfolge würde sich aber für die Solarzellenproduktion anbieten, da man bei diesem Prozess einen sehr gut reflektierenden Silberrückkontakt unterhalb der polykristallinen Halbleiterschicht erhalten würde.

### Lösung durch Titan-unterstützten Metall-induzierten Schichtaustausch

Der von uns entwickelte und bisher in der Literatur noch nicht beschriebene Titan-unterstützte Metall induzierte Schichtaustausch (Titan-assisted metalinduced layer exchange, Ti.MILE) gemäß Anspruch 1 löst die oben genannten Probleme wie folgt:
a) durch das Aufbringen einer Titan-Zwischenschicht und das dadurch erfolgte Ersetzen der Aluminiumoxid- bzw. Silberoxidschicht durch eine Titanoxidschicht lässt sich beim ALILE-Prozess die Keimbildungsenergie gegenüber dem konventionellen Prozess deutlich erhöhen. Dies führt sowohl beim ALILE als auch beim AgILE-Prozess zu deutlich größeren Kristalliten wobei die Prozessdauer in der gleichen Größenordnung verbleibt.
b) durch das Einfügen einer Titan - Titanoxid - Zwischenschicht wird der umgekehrte Silberinduzierte Schichtaustausch ermöglicht.

### Beschreibung des Verfahrens "Titan-unterstützter Metall-induzierter Schichtaustausch"

Zu a)
- Auf ein amorphes oder kristallines Substrat (z.B. Glas, Quarz, Silizium-Wafer) wird eine 20-600 nm (typischerweise 200 nm) dicke Aluminium bzw. Silber-Schicht mit einem geeigneten Verfahren aufgebracht (z.B. thermisches Verdampfen, Elektronenstrahl-Verdampfen, Sputtern, elektrochemisches Aufbringen des Metalls, etc.) auf diese wird eine dünne Titanschicht (typischerweise 2-10 nm) aufgebracht.
- Nach diesem Depositions-Prozess wird das Titan für kurze Zeit (einige Minuten) der Umgebungsluft ausgesetzt. Dieser Schritt ist nicht zwingend notwendig, verbessert aber die Oberflächenstruktur der resultierenden polykristallinen Halbleiter-Schicht.
- Auf das Metall-Titan Schichtsystem wird nun eine Silizium-Germanium-Schicht mit einem geeigneten Verfahren aufgebracht (z.B. thermisches Verdampfen, Elektronenstrahl-Verdampfen, Sputtern, Gasphasenabscheidung, etc.). Die Dicke dieser Schicht sollte vergleichbar mit der Dicke der Metall-Schicht sein.
- Die so gewonnene Probenstruktur wird unterhalb der eutektischen Temperaturen des jeweiligen Material systems getempert (z.B. Si-Al 570°C; Si-Ag 830°C,...), bis sich die Schichtfolge spontan austauscht. Abhängig von der verwendeten Temperatur dauert dieser Prozess zwischen einigen Sekunden bis hin zu einigen zehn Stunden. Die ursprüngliche Schichtstruktur Glas / Metall *l* Titan / amorphes Silizium-Germanium wird dabei in eine Glas / polykristallines Silizlum-Germanium / Titan /Metall Struktur umgewandelt.
- Das Aluminium kann nasschemisch, z.B. mit Salzsäure, von der getemperten Probe entfernt werden. Titan bzw. Titanoxid lässt sich z.B. nasschemisch mit Flußsäure entfernen. Als Ergebnis erhält man eine polykristalline Silizium-Germanium Schicht auf Glas.

Zu b)
- Beim umgekehrten Silber-induzierten Schichtaustausch, wird zuerst die Silizium-Germanium Schicht mit einer der oben genannten Methoden deponiert.
- Diese kann einige Zeit an Luft gelagert werden oder es kann direkt eine dünne (2-10nm) dicke Titanschicht mit einer geeigneten Depositionsmethode aufgebracht werden (siehe a).
- Diese Schichtfolge sollte für einige Minuten einer sauerstoffhaltigen Atmosphäre ausgesetzt werden um die Bildung einer Titanoxidschicht zu ermöglichen. Dies ist nicht zwingend notwendig verbessert aber die Qualität der Schichten.
- Auf dieses Schichtsystem wird nun eine Silberschicht abgeschieden. Die Schichtdicke ist hierbei ähnlich der amorphen Silizium-Germanium-Schicht.
- Die so gewonnene Probenstruktur wird unterhalb der eutektischen Temperaturen des jeweiligen Materialsystems getempert (Si-Ag 830°C; Ge-Ag 650°C), bis sich die Schichtfolge spontan austauscht. Abhängig von der verwendeten Temperatur dauert dieser Prozess zwischen einigen Minuten bis hin zu einigen zehn Stunden. Die ursprüngliche Schichtstruktur Glas 1 amorphes Silizium-Germanium / Titan /Metall wird dabei in eine Glas / Metall / Titan 1 polykristallines Silizium-Germanium Struktur umgewandelt.

### Wesentlich Vorteile gegenüber bereits bekannten Verfahren

Der Vorteil des hier beschriebenen Verfahrens lassen sich wie folgt zusammenfassen:
- *Die dünne Zwischenschicht aus Titan erhöht die Aktivierungsenergie für die Bildung neuer Kristalline und führt so bei vergleichbaren Temperaturen zu deutlich größeren Kristalliten, ohne dabei aber den Gesamt-Prozess zu verlangsamen.*

Die Modifikation des bereits bekannten "Aluminium-induzierten Schichtaustauschs" durch das Einbringen einer zusätzlichen funktionalen Dünnschicht aus Titan, ist als das wesentlich Neue der Erfindung anzusehen.

### Literaturverzeichnis

- [ChaO1I]: I. Chambouleyron, F. Fajardo, A.R. Zanatta, Appl, Phys. Lett. 79, 3233 (2001).
- [Eis03]: C. Eisele, M. Berger, M. Nerding, H.P, Strunk, C.E, Nebel, M.Stutzmann, Thin Solid Films 427, 176 (2003).
- [Gju04]: M. Gjukic, M. Buschbeck, R. Lechner, M. Stutzmann, Appl. Phys, Lett. 85 2134(2004)
- [Gju05]: M. Gjukic, M. Scholz, and M. Stutzmann, Erfindungsmeldung : Silber-induzierter Schichtaustausch (AglLE)
- [Her72]: S.R. Herd, P. Chaudhari, H.M Brodsky, J. ,Cryst-Non Solids 7, 309 (1972).
- [Maj77]: G. Majni, G. Ottaviani,.Appl Phys. Lett. 31, 125 (1977)
- [Nas98]: O. Nast, T. Puzzer, L.M, Koschier, A.B. Sproul, .R.S Wenham, Appl. Phys.Lett. 73, 3214 (1998).
- [Rad91]: G. Radnoczi, A. Robertsson, H.T.G. Hentzell, S.F., Gong M.-A, Hasan, J. Appl. Phys. 69, (1991) 6394

- Weitere Anlagen:: Forschungsantrag zum Förderkennzeichen 0329986

## Patentansprüche

1. Verfahren zur Herstellung einer polykristallinen Schicht mit den Verfahrensschritten:
- Aufbringen einer Schichtfolge, die wenigstens eine amorphe Ausgangsschicht, eine metallische Aktivatorschicht und eine zwischen Ausgangsschicht und Aktivatorschicht angeordnete Zwischenschicht umfasst, auf ein Substrat; wobei die Aktivatorschicht aus Al oder Ag hergestellt wird und wobei die Ausgangsschicht wenigstens ein Element aus der Gruppe Si, Ge enthält; und
- Durchführen einer Wärmebehandlung nach dem Aufbringen der Schichtfolge zur Ausbildung einer polykristallinen Endschicht;
**dadurch gekennzeichnet, dass**
die Zwischenschicht eine Titan - und eine Titanoxidschicht umfasst, wobei die Titanoxidschicht durch das Oxidieren der Titanschicht hergestellt ist.

## Claims

1. A method for producing a polycrystalline layer using the method steps of:
- applying a sequence of layers comprising at least one amorphous initial layer, a metallic activator layer and an intermediate layer disposed between the initial layer and the activator layer, onto a substrate; wherein the activator layer is made of Al or Ag, and wherein the initial layer contains at least one element from the group Si, Ge; and
- performing a heat treatment after applying the sequence of layers for forming a polycrystalline final layer;
**characterized in that**
the intermediate layer comprises a titanium layer and titanium oxide layer, wherein the titanium oxide layer is produced by oxidizing the titanium layer.

## Revendications

1. Procédé de fabrication d'une couche polycristalline comportant les étapes de procédé :
- application, sur un substrat, d'une succession de couches, laquelle comprend au moins une couche de départ amorphe, une couche métallique d'activation et une couche intermédiaire disposée entre la couche de départ et la couche d'activation, la couche d'activation étant fabriquée en Al ou Ag et la couche de départ contenant au moins un élément issu du groupe Si, Ge ; et
- exécution d'un traitement thermique après l'application de la succession de couches afin de constituer une couche finale polycristalline ;
**caractérisé en ce que**
la couche intermédiaire comprend une couche de titane et une couche d'oxyde de titane, la couche d'oxyde de titane étant fabriquée par l'oxydation de la couche de titane.
